# EUROPEAN PATENT APPLICATION

(11) **EP 4 711 626 A1**
(43) Date of publication of application: **18.03.2026**
(21) Application number: 24200701.1
(22) Date of filing: 17.09.2024
(51) Int. Cl.: F15B 11/06, F15B 11/10, F15B 15/28, F15B 19/00, F16K 31/00, H01L 21/687, G06N 20/00, F15B 20/00

(54) **LEARNING FOR CONTROLLING PNEUMATIC DRIVEN POSITIONING DEVICES**

(71) Applicant: VAT Holding AG, 9469 Haag (CH)
(72) Inventor: GRASSO, Emanuele, 9466 Sennwald (CH); ABDELAZIZ, Karim, 8005 Zürich (CH)
(74) Representative: Kaminski Harmann

(57) **Abstract**

The invention relates to a method for providing controlling parameters for controlling a vacuum system (1), the vacuum system (1) comprises at least a first pneumatic positioning device (10) configured for moving and positioning an effecting element in a process atmosphere region which is providable by a vacuum process chamber, wherein the first pneumatic positioning device (10) comprises a first mount configured to hold the effecting element and a first pneumatic actuator which is connected to the first mount and which interacts with the first mount in such a way that the first mount is movable along a first movement axis. The system (1) also comprises a first control valve (21) connected to the first pneumatic actuator and to a first fluid supply (35) and configured to vary the pressure in the first pneumatic actuator to provide movement of the first mount, and a first fluid sensor (22) arranged and configured to measure the pressure of the first pneumatic actuator. The method further comprises applying a first controlling signal to the first control valve (21) to vary the pressure of the first pneumatic actuator and, by that, moving the first mount from a first starting position to a first end position, monitoring the varying pressure of the first pneumatic actuator by means of the first fluid sensor (22), determining when the first mount arrives at the first end position, and deriving the controlling parameters based on processing a set of observed parameters, wherein the set of observed parameters comprises at least the first controlling signal, the varying pressure, and an information concerning the arrival of the first mount at the first end position.

## Description

### FIELD OF INVENTION

The invention relates to a method of providing controlling parameters to control a vacuum system and a respective controller to provide improved driving performance of a pneumatic positioning device for operation in vacuum applications.

### BACKGROUND OF THE INVENTION

Vacuum applications are typically performed in vacuum chamber systems. These applications are performed e.g. in the area of IC, semiconductor or substrate fabrication which must take place in a protected atmosphere as far as possible without the presence of contaminating particles.

The vacuum chamber systems comprise in particular at least one evacuatable vacuum chamber which is provided for receiving semiconductor elements or substrates to be processed or produced and which has at least one vacuum chamber opening, through which the semiconductor elements or other substrates can be guided into and out of the vacuum chamber. For example, in a production plant for semiconductor wafers or liquid crystal substrates, the highly sensitive semiconductor or liquid crystal elements pass sequentially through several process vacuum chambers in which the parts located within the process vacuum chambers are each processed by means of a processing device.

The process chambers often have at least one transfer valve whose cross-section is adapted to the substrate and the robot and through which the substrate can be introduced into the vacuum chamber and, if necessary, removed after the intended processing. Alternatively, a second transfer valve may be provided through which the processed substrate is removed from the hermetic closable chamber.

Moreover, the processing system may comprise one or more peripheral units which are used especially for controlling or regulating the flow of fluid into and/or out of the vacuum chamber. The peripheral units may be provided by a regulation valve which is located between the vacuum chamber and a vacuum provider or another vacuum chamber or by a gas inlet valve, e.g. a mass-flow controller, which is arranged upstream to provide a particular type and amount of a fluid in the vacuum chamber.

A substrate to be processed, e.g. a wafer, is guided, for example, by a suitably designed and controlled robot arm, which can be guided through the opening in the process chamber provided by the transfer valve. The process chamber is then loaded by holding the substrate with the robot arm, introducing the substrate into the process chamber and depositing the substrate in the chamber in a defined manner. The process chamber is emptied accordingly.

For the handling of the substrate and for the exact positioning of the substrate in the chamber, a relatively high accuracy and mobility of the substrate must be ensured. For this purpose, pin lifting systems driven by pneumatic positioning devices (also: pin-lifters) are used which typically provide a plurality of support points for the substrate and thus a load distribution (due to the dead weight of the substrate) over the entire substrate. The pins can be lowered after depositing the substrate and are then present separated from it, i.e. there is no contact between the pins and the substrate. By that, the substrate can be lifted and deposited on a support structure, like a chuck. After removing the robot arm and closing (and introducing process fluid or evacuating) the chamber, the processing step can be performed.

After processing of the substrate, the substrate has to be raised again. Here, a low force effecting the substrate is particularly important, as the substrate can adhere to the carrier, for example. If the substrate is pushed away from the carrier too quickly, the substrate may break, as the adhesive forces cannot be overcome or resolved at least at certain contact points (waver sticking). In addition, even if contact is established between the support pins and the substrate, any impact with the substrate can lead to undesired stress (or breakage).

At the same time, in addition to the gentlest possible and careful treatment of the substrates to be processed, the shortest possible processing time should also be made possible. This means that the substrate should be brought into the defined conditions - loading and unloading position and processing position - in the chamber as quickly as possible. Pneumatic positioning devices with pneumatic actuators are therefore preferred.

To avoid unwanted shocks during the processing of semiconductor wafers, for example, US 6,481,723 B1 recommends the use of a special stop device instead of hard motion stops in a pneumatic positioning device. Any hard stops should be replaced here by a combination of a softer designed stop part and a hard stop, wherein the contact with the soft stop part is first made for the limitation of movement and then the hard stop is brought into contact with the soft stop part and damped accordingly.

US 6,646,857 B2 proposes a regulation of the lifting movement by means of a recorded occurring force. The lifting pins can be moved as a function of the force signal received so that the lifting force at the lifting pins is always applied to the wafer in a controlled and dosed manner.

Moreover, with view to handling a substrate, it is further important to provide homogeneous movement of the lift pins to provide contact of all pins with the substrate at the same time where possible. Further, the pins should be moved with identical speed and accelerations. Both these requirements provide advantageous distribution of touching force over the entire substate as well as horizontal alignment and transportation of the substrate.

Hence, on the one hand a proper controlling of the pneumatic positioning devices is required and on the other hand the lifters should be built as simple, in particular without any electronical components to avoid (electro-magnetic) influences on substrate processing, in particular when using a plasm generator. Moreover, with view to a system of several pneumatic positioning devices, different driving behaviors of individual pneumatic positioning devices may result in problems of adequate wafer handling. Here, differences in tolerances can occur in various aspects such as spring stiffness, different friction coefficients, mechanical dimensions/parameters or at a proportional valve level to provide particular pressurization of a lifter.

Further, technological deviations or nonlinear dynamics of a pneumatic positioning device also dependent on particular ambient and operating conditions which, thus, influence the driving performance respectively. This can render physics and parameter-based driving approaches inaccurate, e.g. when estimating a position in the absence of a position sensor or even ineffective when such approaches change for instance with usage and time (e.g. a spring constant changes due to usage).

Similar requirements apply for a vacuum valve, e.g. a transfer valve or a regulation valve, as well. It is important to provide precisely controlled and homogeneous movement of a valve closure to provide a desired touching force between the valve closure and the valve seat or the position of the valve closure.

A vacuum valve and its driving unit should be built as simple, preferable without any electronical components in order to avoid (electro-magnetic) influences on vacuum processing, especially when using a plasm generator. Moreover, also technological deviations or nonlinear dynamics of separate vacuum valves also depend on ambient and operating conditions which, thus, influence the driving performance respectively. This can render physics and parameter-based driving approaches inaccurate, e.g. when estimating a position in the absence of a position sensor or even ineffective when such approaches change for instance with usage and time (e.g. a spring constant changes due to usage).

### OBJECT OF THE INVENTION

It is therefore the object of the present invention to provide an improved method for controlling a system with pneumatic positioning devices for vacuum applications which reduces or avoids the above disadvantages.

In particular, it is an object of the invention to provide the method with an improved pneumatic actuating system which enables reliable movement of one or several pin lifting devices and/or vacuum valves arranged.

These objects are solved by implementing the characteristic features of the independent claims. Features which further develop the invention in an alternative or advantageous way can be found in the dependent claims.

### SUMMARY OF THE INVENTION

The approach according to the invention proposes to remedy above issue by of generating proper controlling parameters or a data-driven model for determining or estimating a position of the lift pin or a vacuum valve closure, i.e. of its mount, in an arrangement without a position sensor or the like. A training or learning algorithm is proposed to be used to generate the data or the model during a training or learning stage (cycle) considering at least one known position and, in particular, further operating quantities like voltage, pressure, flowrate, and temperature.

On performing such system learning respective controlling parameters can be derived or a model can be generated using these quantities and parameters to estimate a position based on the control input and the mentioned parameters, in particular based on an applied controlling signal and/or measured pressure.

Furthermore, a data-driven model can also account for estimating the effects of other parameters such as the dependency of lubricant properties due to ambient changes. Deviations from the data-driven model can show a degradation in a wafer-lifter or vacuum valve system or unintended operation conditions. Hence, further or repeated training cycles can be performed to (re-)calibrate the model if its parameters change over time (e.g. with usage).

This provides e.g. also for reduction of undesirable effects of device-to-device technological differences and improves the accuracy of positioning.

The invention relates to a method for providing controlling parameters for controlling a vacuum system. The vacuum system comprises at least a first pneumatic positioning device configured for moving and positioning an effecting element, in particular in a process atmosphere region which is providable by a vacuum process chamber.

The first pneumatic positioning device comprises a first mount configured to hold the effecting element. The effecting element can be embodied as a lift pin or valve closure .

The first pneumatic positioning device also comprises a first pneumatic actuator which is connected to the first mount and which interacts with the first mount in such a way that the first mount is movable along a first movement axis, in particular from a lowered normal position into an elevated lifting position, and back again.

A first control valve is provided and connected to the first pneumatic actuator and to a first fluid supply and configured to vary at least one of the pressure in the first pneumatic actuator and the fluid flow out of or into the first pneumatic actuator to provide movement of the first mount, in particular in an extending direction.

A first fluid sensor is arranged and configured to measure at least one of the pressure of the first pneumatic actuator or the fluid flow out of or into the first pneumatic actuator, in particular the pressure in a pressure chamber of an actuating cylinder of the actuator.

The method comprises applying a first controlling signal to the first control valve to vary at least one of the pressure of the first pneumatic actuator and the fluid flow into the first pneumatic actuator and, by that, moving the first mount from a first starting position to a first end position.

The first end position is to be understood as a position not necessary limiting the moveability of the mount but to be a position which can be reached by the mount when moving the mount. The end position can in particular correspond to a full-stroke of a moving member or the mount, i.e. a position which is limited by a hard stop. Alternatively, the first end position can be provided by a position of contacting a substrate with a lift pin, or any other position which can be determined or measured respectively (also described in more detail below).

At least one of the varying pressure of the first pneumatic actuator or the varying fluid flow into the first pneumatic actuator is measured by means of the first fluid sensor and it is determined when the first mount arrives at the first end position, in particular based on monitoring or analyzing the varying pressure.

The controlling parameters are derived based on processing a set of observed parameters, wherein the set of observed parameters comprises at least the first controlling signal, the varying pressure, and an information concerning the arrival of the first mount at the first end position.

In one embodiment, the set of observed parameters can comprise an information concerning the first starting position and the first end position. As already described for the first (and any other) end position, the first (and any other) starting position may be a known position which the mount can be provided at.

According to one embodiment, the varying pressure of the first pneumatic actuator and/or the varying fluid flow can be processed and the arrival of the first mount at the first end position is determined based on the varying pressure or the varying fluid flow. As for example, in case the end position correlates with reaching a hard stop, a fluctuation (e.g. peek) in the pressure profile can represent reaching the hard stop.

In one embodiment, the vacuum system can comprise a position sensor to measure the position of the first mount and the arrival of the first mount at the first end position is determined based on measuring or monitoring the position of the first mount by means of the position sensor. A positioning of the first mount in the first starting position can be detected accordingly.

In one embodiment, the controlling signal, in particular a voltage or current, can be monitored and an information about a development or variation of the controlling signal can provide an additional parameter of the set of observed parameters. Such monitoring allows to adjust the controlling signal precisely to result in determined adjustment of a control valve setting.

According to an embodiment, the vacuum system can comprise at least one temperature sensor which is configured and arranged to provide temperature information by measuring at least one of an ambient temperature, a temperature related to of the first pneumatic positioning device, and a temperature related to the first control valve. The temperature information is determined by means of the at least one temperature sensor, and the temperature information is provided as an additional parameter of the set of observed parameters to be processed.

In one embodiment, the vacuum system can comprise at least one fluid flow sensor configured and arranged to provide flowrate information by measuring at least one of a fluid flow between the first control valve and the first pneumatic actuator, a fluid flow between the first control valve and the first fluid supply, and an exhaust fluid flow out of the first control valve. The flowrate information can be determined by means of the at least one fluid flow sensor, and the flowrate information is provided as an additional parameter of the set of observed parameters to be processed. In particular, the first fluid sensor is provided by the at least one fluid flow sensor.

According to an embodiment, the vacuum system can comprise at least one pressure sensor configured and arranged to provide pressure information by measuring at least one of an inlet pressure into the first pneumatic actuator, an outlet pressure downstream the first control valve, a supply pressure provided by the first fluid supply, an exhaust pressure related to an exhaust line connected to the first control valve, and an ambient pressure.

The pressure information can be determined by means of the at least one pressure sensor, and the pressure information can be provided as an additional parameter of the set of observed parameters to be processed, in particular wherein the first fluid sensor is provided by the at least one pressure sensor.

In one embodiment, a position of the first mount can be estimated or derived based on processing of the set of observed parameters. In other words, the position of the first mount can be calculated by means of processing the first controlling signal, at least one of the varying pressure or the varying fluid flow, and an information concerning the arrival of the first mount at the first end position. A model of the pneumatic positioning device may additionally be used for providing such estimation.

In one embodiment, a digital model can be provided based on the set of observed parameters, the model representing dynamic properties of the at least first pneumatic positioning device by model state variables, the model state variables are related to physical properties of the first pneumatic positioning device and provide deriving of an actual state of the first pneumatic positioning device.

In particular, the controlling parameters can be derived based on the model state variables or the model state variables represent the controlling parameters, in particular wherein the controlling parameters are replaced by the model state variables.

An actual position of the first mount can be determined by deriving the actual state of the first pneumatic positioning device.

An influence on at least one of the physical properties of the first pneumatic positioning device is determined or estimated based on the actual state of the first pneumatic positioning device.

In one embodiment, an actual pressure of the first pneumatic actuator is measured by the first fluid sensor and an actual load affecting the mount is derived by processing the model state variables or the set of observed parameters, and the actual pressure.

The actual load affecting the mount can continuously be monitored by continuously measuring the actual pressure of the first pneumatic actuator and continuously deriving the actual load.

The derived actual load can be compared to an expected load and a load information can be derived by the comparison.

In one embodiment, a first dynamic target behavior for the first pneumatic positioning device is derived based on the set of observed parameters, the first pneumatic positioning device is driven according to a production cycle and, concurrently, a first actual dynamic behavior of the first pneumatic positioning device is derived, and a behavior deviation information is derived and provided based on comparing the first dynamic target behavior and the first actual dynamic behavior. This may provide detecting any deviations or errors during operation of the first pneumatic positioning device.

According to one embodiment, the method can provide second controlling parameters for controlling the vacuum system, the vacuum system can accordingly comprise a second pneumatic positioning device, which comprises a second mount configured to hold at least one effecting element, and a second pneumatic actuator which is connected to the second mount and which interacts with the second mount in such a way that the second mount is movable along a second movement axis.

Further, a second control valve can be connected to the second pneumatic actuator and to a second fluid supply and configured to control at least one of pressurizing of the second pneumatic actuator and fluid flow out of or into the second pneumatic actuator to provide movement of the second mount.

A second fluid sensor can be arranged and configured to measure at least one of pressurization of the second pneumatic actuator and/or fluid flow out of or into the second pneumatic actuator.

The method can further comprise applying a second controlling signal to the second control valve to vary at least one of the pressure of the second pneumatic actuator and the fluid flow into the second pneumatic actuator and, by that, moving the second mount from a second starting position to a second end position, and monitoring at least one of the varying pressure of the second pneumatic actuator and/or the varying fluid flow into the second pneumatic actuator by means of the second fluid sensor.

The method can further comprise determining when the second mount arrives at the second end position, and deriving the second controlling parameters based on processing a second set of observed parameters, wherein the second set of observed parameters comprises at least the second controlling signal, at least one of the varying pressure of the second pneumatic actuator and/or the varying fluid flow, and an information concerning the arrival of the second mount at the second end position.

In particular, a second dynamic target behavior for the second pneumatic positioning device can be derived based on the second set of observed parameters, the second pneumatic positioning device can be driven according to a production cycle and, concurrently, a second actual dynamic behavior of the second pneumatic positioning device can be derived, and a second behavior deviation information can be derived and provided based on comparing the second dynamic target behavior and the second actual dynamic behavior.

In one embodiment, the first pneumatic positioning device and the second pneumatic positioning device can be driven according to a production cycle, driving performances of the first pneumatic positioning device and the second pneumatic positioning device can be monitored, the driving performances of the first pneumatic positioning device and the second pneumatic positioning device can be compared, and a performance information is derived and provided based on the comparison.

In one embodiment, the first and/or second pneumatic positioning device can be a pin lifting device for moving and positioning a substrate to be processed by means of a lift pin, the mount is configured to hold the lift pin designed for contacting and supporting the substrate and forming the effecting element, and the first pneumatic actuator provides a linear adjustability of the mount.

In one embodiment, the first and/or second pneumatic positioning device can be a vacuum valve for regulating a volume or mass flow or for gas-tight interruption of a flow path. The vacuum valve comprises a valve seat comprising a valve opening defining an opening axis and a first sealing surface surrounding the valve opening.

The valve further comprises a valve closure forming the effecting element having a second sealing surface corresponding to the first sealing surface, wherein the valve closure is coupled to the pneumatic actuator by means of the mount in such a way that the valve closure is adjustable from an open position, in which the valve closure and the valve seat of the vacuum valve are present in a contactless manner relative to each other, to a closed position, in which a sealing contact between the first sealing surface and the second sealing surface exists via an interposed seal and the valve opening is thereby closed, in particular in a gas-tight manner, and is adjustable back again. The mount is designed to hold the valve closure.

The invention also relates to a controlling unit for a vacuum system, the vacuum system comprises at least a first pneumatic positioning device configured for moving and positioning an effecting element, in particular in a in a process atmosphere region which is providable by a vacuum process chamber, the at least first pneumatic positioning device comprises a first mount configured to hold the effecting element, and first pneumatic actuator which is connected to the first mount and which interacts with the first mount in such a way that the first mount is movable along a first movement axis.

The vacuum system also comprises a first control valve connected to the first pneumatic actuator and to a first fluid supply and configured to vary at least one of the pressure in the first pneumatic actuator and the fluid flow out of or into the first pneumatic actuator to provide movement of the first mount.

Further, a first fluid sensor is arranged and configured to measure at least one of the pressure of the first pneumatic actuator and the fluid flow out of or into the first pneumatic actuator.

The controlling unit is configured to apply a first controlling signal to the first control valve to vary at least one of the pressure of the first pneumatic actuator and the fluid flow into the first pneumatic actuator and, by that, moving the first mount from a first starting position to a first end position.

The controlling unit is further configured to monitor at least one of the varying pressure of the first pneumatic actuator and the varying fluid flow into the first pneumatic actuator by means of the first fluid sensor, to determine when the first mount arrives at the first end position, and to derive the controlling parameters based on processing a set of observed parameters, wherein the set of observed parameters comprises at least the first controlling signal, at least one of the varying pressure and the varying fluid flow, and an information concerning the arrival of the first mount at the first end position.

In particular, the controlling unit is configured to execute any embodiment of a method described above.

The invention also relates to a computer program product stored on a machine-readable carrier, in particular stored in a controlling unit according to above, or embodied by an electromagnetic wave with a program code segment, with program code for performing or controlling a method of above, wherein the computer program product comprises computer-executable instructions for performing a method according to above, in particular wherein the computer program product is configured such that when it is executed, the steps of a method according to above are performed automatically.

### BRIEF DESCRIPTION OF THE DRAWINGS

The method according to the invention and the controlling unit according to the invention are described in detail hereinafter merely as an example with reference to specific exemplary embodiments shown schematically in the drawings, wherein further advantages of the invention are also discussed. In detail in the figures:
Figure 1 shows an embodiment of a vacuum system according to the invention.
Figure 2 shows another embodiment of a vacuum system according to the invention.
Figure 3 shows another embodiment of a vacuum system according to the invention.
Figure 4 shows another embodiment of a vacuum system according to the invention.
Figure 5 shows another embodiment of a vacuum system according to the invention.
Figure 6 shows the steps of performing an embodiment of a method according to the invention.

### DETAILED DESCRIPTION OF THE DRAWINGS

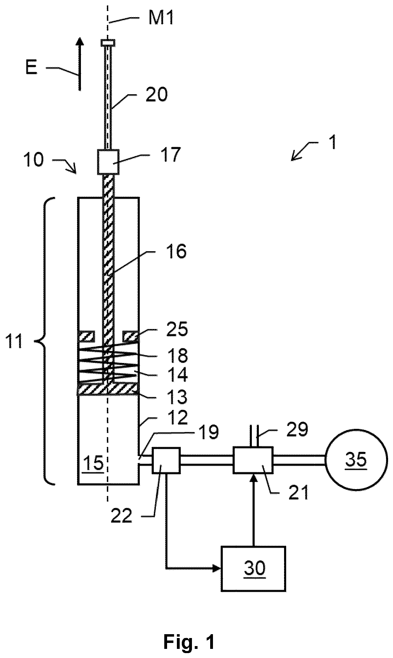

Figure 1 shows schematically an embodiment of a vacuum system 1 according to the invention.

The vacuum system 1 comprises a pneumatic positioning device embodied as a pin lifting device 10 with a pneumatic actuator 11. The pneumatic actuator 11 comprises a cylinder 12 separated into two chambers 14,15 by a moving member 13. The moving member 13 may preferably be a piston. A stem 16 is connected to the moving member 13 and extends outside the inner volume of the cylinder 12. The stem 16 is configured to provide actuation of a connected first mount 17 to be moved. A lift pin 20 is attached to the mount 17. Hence, a load is applied to the moving member 13 by the stem 16, i.e. by the weight of the stem 16, and/or by an additional element which interacts with the stem 16, like the lift pin 20 or a lifted substrate.

The pneumatic actuator 11 further comprises a first fluid passage 19. The first fluid passage 19 enables fluid flow into and out of the first chamber 15.

Further, the pneumatic actuator 11 comprises a restoring element 18, in particular a spring. The restoring element 18 is connected to the moving member 13 and applies a restoring force to the moving member 13. In the shown embodiment, the restoring element 18 is arranged inside of the second chamber 14. The restoring force acts downwards to move the moving member 13 accordingly (depending on the pressure in the chamber 15).

The system 1 also comprises a first control valve 21 connected to the first fluid passage 19 and to a fluid supply 35 and configured to provide controlling of fluid flow into the first chamber 15. The fluid supply 35 may be provided by a high-pressure fluid source, e.g. a reservoir of compressed air. The first control valve 21 may be a proportional control valve capable of providing a defined fluid flow as a function of a respectively applied controlling signal.

The control valve 21 provides controlled varying of a flow and/or pressure into the chamber 15.

A first fluid sensor 22 is arranged and configured to measure the pressure in the first chamber 15, i.e. at one side of the pneumatic cylinder. Here, the first fluid sensor is embodied as a pressure sensor 22 and provides pressure feedback from the first chamber 15, i.e. a pressure affecting the moving member 13.

In an alternative embodiment, the first fluid sensor 22 can be a flow meter to measure fluid flow out of the control valve 21 and/or into the chamber 15. Such flow meter can also provide to measure fluid flow out of the chamber 15.

As shown, the first fluid sensor 22 can be arranged close to or integrated with the pin lifting device 10. Alternatively, the first fluid sensor 22 can be located along a supply line for the respective chamber 15. Further, the sensor 22 may be arranged together with the respective control valve 21 or may be located separated from the valve 22.

The vacuum system 1 comprises a controlling unit 30. The controlling unit 30 is configured to control a movement of the moving member 13 by applying a particular pressure in the chambers 15. The pressures in the chambers 15 can be varied by controlling the control valve 21 to increase or decrease the pressure in the chamber 15.

The controlling unit 30 is connected with the pressure sensor 22 to receive pressure information related to the chamber 15.

The controlling unit 30 is configured to derive and generate respective controlling signals for the first control valve 21. The controlling signals can provide to set and vary a pressure inside of the first chamber 15 and, by that, to set and vary a force counteracting the restoring force of the restoring element 18.

In an alternative embodiment (not shown) the pneumatic positioning device can be built to comprise two pressure chambers, each chamber on one side of the moving member, wherein both chambers can individually be pressurized. Accordingly, two control valves can be provided to pressurize the chambers. Here, no restoring element is provided but the movement of the moving member can be provided by setting and varying the pressures in the chambers and/or the respective difference pressure. The controlling parameters (as described below in more detail) can be provided to control the two control valves to provide desired movement of the moving member.

According to the invention, the movement of the pin lifter 10, i.e. of the mount 17, can be controlled based on respective controlling parameters. A respective process or cycle can be run to derive the controlling parameters. For that, a first controlling signal is applied to the first control valve 21 to vary the pressure in the first pneumatic actuator 11, i.e. in the chamber 15, and, by that, moving the first mount 17 from a first starting position to a first end position.

For that, the first mount 17 is preferably provided in the first starting position. The first starting position can correspond to a "zero" position, i.e. a position the mount 17 and the moving member 13 are provided retraced, e.g. in a lowest possible position. Alternatively, the mount 17 is provided in an alternative position which is determined respectively.

The varying pressure of the first pneumatic actuator 11, which is a result of applying the first controlling signal, is monitored by means of the first fluid sensor 22. Further, it is determined when the first mount 17 arrives at the first end position.

The varying pressure will preferably be represented by a rise of the pressure in the first chamber 15 to move the mount 17 in extending direction E.

The first end position can correspond to a full-stroke of the moving member 13, i.e. a position which is provided when the moving member 13 reaches a hard stop 25 provided inside the cylinder 12.

Alternatively, the first end position can be provided by a position of contacting the substrate with the lift pin 20, or any other position which can be determined respectively.

Reaching the first end position by the mount 17 can be detected by means of arranging a position sensor and monitoring the position or a change of position of the mount 17.

Reaching the first end position by the mount 17 can alternatively be detect by the controlling unit 30 by measuring pressurization of the first pneumatic actuator by the first pressure sensor 22 and monitoring a change of the pressure in the first pneumatic actuator. As for example, when contacting the hard stop 25 with the moving member 13 the course of a time-pressure curve can preferably deviate from a homogenous development and provides a pressure peak to be detected.

This means that the moment in time when the mount reaches the end position can be detected by means of the pressure sensor 22 and the controlling unit 30.

The controlling parameters are then derived based on processing of a set of observed parameters. The set of observed parameters comprises at least the first controlling signal, the varying pressure, and an information concerning the arrival of the first mount at the first end position.

In other words, the controlling parameters are learned by performing the aforementioned steps. Such controlling parameters provide controlling of the pin-lifter 10 via controlling the control valve 21 according to defined movement cycle. The learned controlling parameters allow to set a defined position of the mount 17 or a defined velocity and/or acceleration of the mount 17 for reaching a particular lifting position by applying a respectively adjusted controlling signal.

Controlling of the control valve 21 can result in increasing or decreasing the pressure in the first chamber 15. The control valve can comprise an exhaust channel 29 to let fluid flow out of the first chamber 15.

Moreover, based on the set of the observed parameters, a digital model is provided. The model can be generated or adapted based on the observed parameters. The model represents dynamic properties of the at least first pin lifting device 10 by model state variables, the model state variables are related to physical properties of the first pin lifting device 10 and provide deriving of an actual state of the first pin lifting device 10.

The controlling of the vacuum system 1 can respectively be performed by use of the digital model.

A position of the mount 17 can be derived or estimated based on the model, e.g. by processing the actual model state variables. The mount 17 can respectively be controlled to move along the movement axis M1 to be set into a desired position.

Since the model state parameters describe the vacuum system 1 and allow to calculate an actual state, a relation between an applied pressure in the chamber 15 and the (estimated) position of the mount 17 is known from the model as well. Further, a respective state of the control valve 21, which state represents the actual pressure in the chamber 15, and the related actual position is known. Accordingly, a possible change of the controlling signal, e.g. a change of the applied voltage, can be derived in a way to accurately change the position of the first mount 17 as desired.

For instance, the model can also be processed to derive an actual load affecting the mount 17 as a function of an actual pressure measured by the the first fluid sensor 22 and of a currently applied controlling signal.

Based on determining a load which affects the mount 17 or based on monitoring an actual dynamic behavior of the pneumatic positioning device 10, further information related to a processing cycle can be derived. As for instance, in case the detected load exceeds a defined load threshold when lifting a substrate this can give information about so called wafer sticking, i.e. the substrate does unintentionally adhere on a chuck or the like. As a consequence, a lifting motion of the pin can be slowed down or interrupted to avoid breakage of the wafer.

Making use of a digital model as of above, such controlling and monitoring can be provided by exclusively measuring the pressure in the chamber and further using (processing) the model parameters. No further sensor has to be arranged which may enable determining a force and/or position related to the mount.

Further, by monitoring the pressure in the first chamber 15 and by deriving the load applied to the mount 17 based thereon, a possible breakage of a substrate can also be detected.

As for example, the pressure is detected to first increase homogenously as desired and, successively, the increase of pressure accelerates. Given an applied controlling signal which should result in continuous homogeneously pressure increase, such pressure development represents an (e.g. unexpected) increase of the load applied to the mount 17. The increased load may represent a contacting event where the lift pin contacts the substrate to be lifted.

By further monitoring the pressure and estimating the applied load a lift off of the substrate (e.g. from a chuck) can be detected in the event that the load does not exceed a defined low threshold and successively decreases again. In case the load exceeds the low threshold level, such event may be identified as so-called wafer sticking which means that the substrate cannot be separated from the chuck as expected. Further, if the load further increases and also exceeds a second high threshold level and later decreases again, this may correspond to a breakage of the substrate due to applying too much load (force) to the substrate.

An intermediate event of wafer sticking but later separation of the wafer from the chuck can be detected if the pressure or the load exceeds the lower threshold but not the higher threshold and a decrease of pressure starts in between these thresholds.

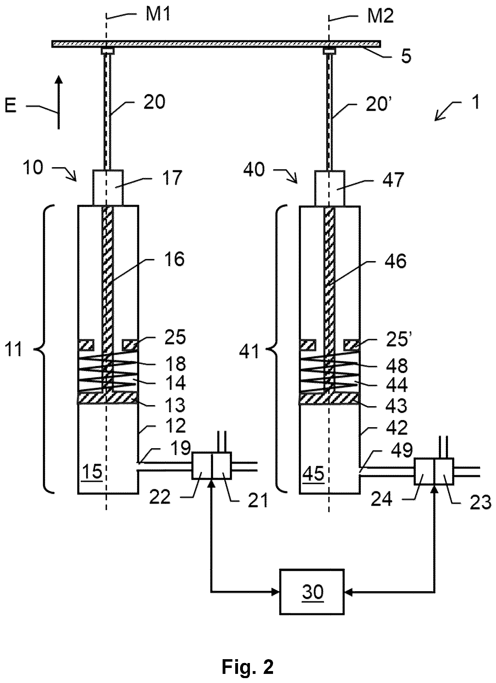

Figure 2 shows an embodiment of a vacuum system 1 according to the invention. In contrast to the embodiment of figure 1, here, a second pneumatic positioning device, also embodied as a pin-lifting device 40, second control valve 23 and a second fluid sensor 24 are arranged. Both pin lifting devices 10 and 40 are provided to handle a substrate 5, e.g. a semiconductor wafer, in a vacuum atmosphere. Hence, the lift pins 20 and 20' can be provided in a vacuum chamber while the respective pneumatic actuators 11 and 41 can be arranged outside of the vacuum chamber.

As mentioned above, the substrate is required to be handled with high precision, meaning the substrate should be lifted and lowered such that it remains horizontally aligned and not misalignment occurs. For that, the loads (forces) applied to the substrate by the pin lifting devices 10 and 40 should individually not exceed a particular load threshold and/or the load should preferably be distributed homogenously across the substrate.

As can be seen the second pin lifting device 40 comprises a second pneumatic actuator 41 which comprises a second cylinder 42, a second moving member 43, respective third and fourth chambers 44 and 45 inside of the cylinder 42, a second stem 46 and a second restoring element 48. Further, the second pin lifting device 40 comprises a second mount 47, a second hard stop 25' and a second fluid passage 49. The second mount 48 is moveable long a second moving axis M2.

The second control valve 23 and the second fluid sensor 24 are connected to the controlling unit 30.

The controlling unit 30 is configured to provide adjustment of the motion profile of at least one of the two pin lifting devices 10 and 40 by providing the respective controlling signals for both lifters 10,40.

For that, a calibration or learning cycle as mentioned above can be performed with both pin lifting devices 10 and 40.

Hence, moving of the first 17 and of the second mount 47 from respective (first and second) starting positions to respective (first and second) end positions by applying a respective (first and second) controlling signals to the respective (first and second) control valves 21, 23 is provided (controlled) by the controlling unit 30. The varying pressures in the first and the second actuator are monitored and respective arrivals at the end positions are detected.

Based thereon, the controlling parameters can be derived by processing sets of observed parameters, wherein the observed parameters relate to at least the (first and second) controlling signal, the varying pressures of the (first and second) pneumatic actuators, and information concerning the arrival of the (first and second) mount at the (first and second) end positions.

Given the known controlling signals and the known (or precisely measured) end positions and their arrivals, based on such learning (by measuring) of the pressure developments in the actuators respective positions of the mounts 17,47 along their movement axes M1,M2 can continuously be determined or estimated.

For that, a respective digital model can be derived based on the observed and known parameters. The digital model may be generated individually for each of the system components, or an overall model may be generated which describes the dynamics of the each such component.

The respective spring constants of the restoring elements 18,48 and their influences on the moving members 13,43 and thus in the mounts 17,47 may be known as well. By that, a load applied by the restoring elements can be assumed to be known and constant.

However, due to usage and/or time the properties (e.g. stiffnesses) of the resorting elements 18,48 may change. Applying a learning cycle as described above allows to re-calibrate precise controlling and/or to adjust a digital model describing the respective lifter 10,40 and thus to adjust the controlling according to changed physical properties. A change of a spring constant (or any other structural change) can thus be taken into account.

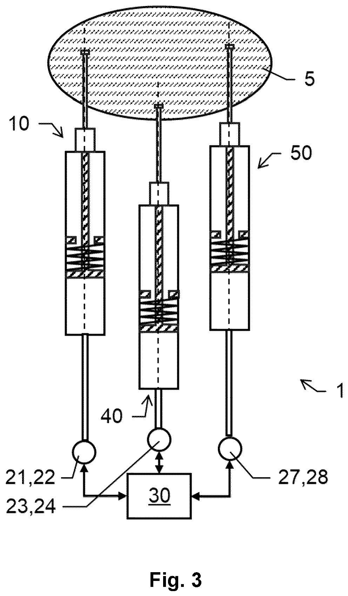

Figure 3 shows an embodiment of a vacuum system 1 according to the invention. In contrast to the embodiment of figure 2, here, three pin lifting devices 10, 40 and 50 with respective control valves 21, 23 and 27 and pressure sensors 22, 24 and 28 are arranged as pneumatic positioning devices. The pin lifting devices 10,40,50 are provided to handle a substrate 5, e.g. a semiconductor wafer, in a vacuum atmosphere.

The controlling unit 30 is connected to the respective control valves 21,23,27 and to the pressure sensors 22,24,28 to acquire pressure information regarding the pneumatic actuators of the lifters 10,40,50 and to apply respective controlling signals to the control valves 21,23,27 to move the lifters.

The controlling parameters to control the pin lifting devices can be derived according to a method describe herein. Accordingly, respective digital models for the lifters and/or an overall model can be derived.

The controlling unit 30 is configured to monitor the motion characteristics of the pin lifting devices 10,40,50. The loads applied or the forces affecting the lifters can be derived or estimated for each of the lifters individually. Hence, a distribution of the loads applied to the substrate 5 can be derived.

Respectively, the controlling unit 30 can provide to detect any inhomogeneity of load distribution, e.g. by comparing the loads individually derived for the lifters 10,40,50. Such difference in applied loads allows to determine possible misalignment of the wafer 5 on the lift pins, e.g. if the wafer 5 is offset from its ideal (central) position relative to the lifters 10,40,50. For instance, if the center of the wafer 5 would be offset towards to the lifter 50, the load applied on the lifter 50 would result to be higher than the loads of the lifters 10 and 40.

A misaligned of the wafer 5 can also be detected via unequal pressure distribution or by a change of such distribution relative of an expected pressure distribution concerning the pressures applied to pneumatic actuators of the lifters 10,40,50. If the pressure of one of the lifters differs more than expected from the pressures of the other lifters, this may be a clear indication for the misalignment.

Further, a non-horizontal, i.e. tilted, orientation of the wafer 5 can also be detected. This can for example be provided either by individually estimating the positions of the lift pins (based on the observed parameters like the applied controlling signal and the measured pressure) and comparing the so derived position information. In case of deriving a deviation of positions this may be a hint on respective tilting. Further, tilting may be identified based on comparing the loads applied to the pin lifters. In case at least one of the applied loads significantly differs from the other loads this may also be identified as a wafer tilting.

Discrimination between a position offset and a tilting of the wafer can be done based on the distribution of the loads and the deviations of the applied loads. E.g. if the loads of two of the lifters do not differ but the load of the third lifter significantly differs, this may be identified as an offset of the substrate towards the third lifter.

Another aspect relates to detecting of inhomogeneity with the pin-lifters 10,40,50 from the pressure measurements. Given the position of the substrate 5 is known and it is correctly placed, the pin lifters 10,40,50 can be controlled to approach and contact the substrate 5. The respective touching points can be derived by measuring the pressures. Respectively, possible pressure difference can be detected here. Based on such a difference a possible defect or deviation of a respective lifter can be determined.

An information about the touching positions can further be processes to train the model or to adjust the controlling parameters, e.g. to learn a respective pressure level for each lifter which pressure level is connected to a particular reference (touching) position.

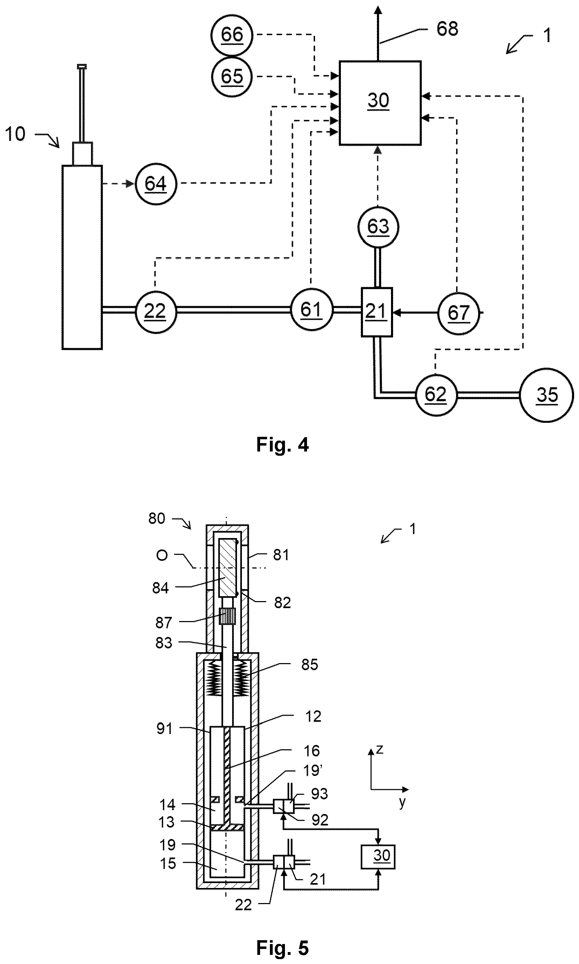

Figure 4 shows a further embodiment of a system 1 according to the invention. The system 1 is based on a vacuum system according to figure 1, wherein the system 1 comprises a pin lifting device 10, a controlling unit 30 and a control valve 21.

The system 1 further comprises various sensors to acquire process information which may possibly influence motion performance of the pin lifting device10. During wafer-lifter operations, multiple phenomena such as wafer stick during chucking and de-chucking, wafer or pin-lifter misalignment can compromise the vacuum system performance in addition to potentially creating downtime due to failures. Such failures can be potentially costly in terms of material and downtime for the user.

The shown embodiment aims to detecting such phenomena by means of the sensors and/or by using a respectively applied model, and consequently adapting the control inputs to prevent such failures or by simply notifying the user in the occurrence of such phenomena.

A pressure sensor 22 is arranged to detect the actuating pressure applied to move the pin lifting device 10. A further pressure sensor 61 is arranged to measure the valve outlet pressure. Such additional sensor 61 provides, for instance, to detect a potential leak in the supply line or any other variance of the pressure between the outlet point of the valve and the pressure level at the lifter 10.

Pressure sensor 62 is arrange d between the pressure supply 35 and the control valve 21 and provides information about a current pressure of the actuation fluid (e.g. compressed air). This information helps to predict for a change of the pressure in the actuator as a function of actuating the control valve 21. As for example, the higher the pressure of the supply 35 is, the more rapidly will the pressure increase in the actuator due to an actuation of the control valve 21 (when opening the control valve).

An exhaust pressure sensor 63 makes available a similar information compared to sensor 62. Here, the pressure level for venting the pin lifting device can be measured and, respectively, an influence on decrease of pressure when venting the lifter can be derived.

It is to be understood, according to alternative embodiments of the invention, the pressure sensors mentioned above may alternatively be flowrate sensors which allow to correspondingly derive fluid flow from and to the lifter 10 and the control valve 21.

A position sensor 64 is provided as well. Such position sensor 64 can enable to determine the position of the lift pin or the mount. The sensor 64 may be used to train the digital model or to derive the controlling parameters, i.e. the position sensor 64 can detect when the mount reaches its end position. Further, the position sensor 64 can be used to derive a relationship between an applied pressure and a respective position of the mount. This information can be stored or further processed.

In one embodiment, the position sensor 64 is only temporarily arranged to train the model but is removed after respective training or learning.

Additional input for learning of the controlling parameters and/or for training the model can be provided by a temperature sensor 65 which measures the ambient temperature (related to the pin lifting device 10) and by an ambient pressure sensor 66.

As for example, a temperature information provided by the temperature sensor 65 can be processed to control the pin lifting device 10. The temperature or a change of temperature may have direct and significant influence on the motion characteristics of the pin lifting device 10. E.g. the effect of lubricants used to provide smooth motion of the lifter change with their temperature and thus may cause different performances due to temperature changes.

A sensing unit 67 is provided to measure the controlling signal applied to the control valve 21. The sensor 67 can be configured to measure voltage and/or current and can thus provide a measure directly related to a status of the control valve 21. In one embodiment, the sensor 67 is integrated in the controlling unit 30 and the controlling voltage or current is determined by the controlling unit. The controlling unit 30 may further provide applying the controlling signal as a function of a processing cycle or training routine and, thus, provides a direct relation between the applied controlling signal and desired motion of the pin lifting device 10. This connected information can further provide to adjust the digital model or the controlling parameters.

The controlling unit 30 is configured to process the inputs provided by all the sensors. Respective controlling parameters can be derived based on performing a training cycle as described above and monitoring at least the development of the pressure applied to move in the pin lifting device 10, detecting reaching a particular end position and determining a respective time (duration) for movement until reaching this position. Further, the digital date model can be generated or adapted based on the inputs.

Having learned the dynamic properties of the system 1, the controlling unit 30 can also provide to estimate or predict (or even exactly derive) a particular current state of the pin lifting device 10 according to currently provided inputs. The digital model allows calculating such current pin lifter state by processing at least a part of the inputs. As for example, an actual temperature and an actual pressure are provided to the controlling unit 30 and the controlling unit 30 processes the measure of the actual pressure to derive an estimated position of the lift pin and further processes the measured temperature to adjust the estimation of the current position based on pre-learned influences of varying temperature on the pin lifting state.

Such estimated or calculated actual state of the pin lifting device 10 can be provided as respective model output or algorithmic output 68.

The system according to figure 4 allows to estimate a load applied at the pin-lifter 10, e.g. by measuring pressure signals. In addition, a de-chucking (lifting off of the substrate from a support) can be detected via the change in pin-lifter load and subsequently by the pressure signals. Analogously, the control input (to control the control valve 21) can be adapted to avoid wafer breakage in such events.

Possible wafer breakage can also be detected.

Further, a misalignment of a wafer can be detected by means of unequal pin-lifter load or unequal or unexpected pressure distribution. The other way round, if the wafer position is known and it is correctly placed, inhomogeneities with several pin-lifters can be detected from the pressure measurements.

It is to be understood that in an alternative embodiment, the pin lifter 10 can be replaced by a vacuum valve or a vacuum valve can additionally be provided and controlled by the system. A respective vacuum valve comprises a mount which is arranged to hold the valve disk (effecting element) and a pneumatic actuator which is connected to the mount and which interacts with the mount in such a way that the mount (an a mounted valve disk) is movable along a first movement axis.

The controlling and/or learning for such vacuum valve can be provided according to above described approach.

Figure 5 shows another embodiment of a vacuum system 1 according to the invention. The vacuum system 1 comprises a pneumatic positioning device which is build as a vacuum valve 80, here a vacuum slit valve. The vacuum valve 80 has a valve housing with a valve wall that has an opening 81 with an opening axis O and with an elongated, essentially rectangular valve seat 82 that surrounds the opening 81. A closure element 84 with a closing side, especially one provided on the process side, which has a slightly larger cross-section than the opening 81, serves to close the opening 81 in a substantially gas-tight manner by pressing the closing side onto the valve seat 82. The closure element 84 is supported by a valve rod 83. The closure element 84 is connected to the valve rod 83 by means of a mount 87. The mount 87 can be realized e.g. by screwing or clamping.

The valve housing is divided into a vacuum region, in which the opening 81, the valve seat 82 and the closure plate 84 are located, and a drive region, which is outside the vacuum region.

The valve rod 83 is passed through a gas-tight feedthrough, which is designed as diaphragm seals or diaphragm bellows 85 (as shown), which seals at their end pieces (e.g. O-rings) inside the valve housing the vacuum region from the drive region.

A pneumatic actuator 91 is provided in the drive region. The pneumatic actuator 91 is built similar to the actuator 11 of figure 1. The pneumatic actuator 91 comprises a cylinder 12 separated into two chambers 14,15 by a moving member 13. The moving member 13 may preferably be a piston. A stem 16 is connected to the moving member 13 and extends outside the inner volume of the cylinder 12. The stem 16 is configured to provide actuation of the connected mount 87 to be moved. The stem 16 may be connected to the valve rod 83 or may directly build the valve rod, i.e. may provide the valve rod 83.

The valve closure 84 is attached to the mount 87. Hence, a load is applied to the moving member 13 by the stem 16, i.e. by the weight of the stem 16, and/or by an additional element which interacts with the stem 16, like the valve closure 84.

The pneumatic actuator 91 further comprises a first fluid passage 19. The first fluid passage 19 enables fluid flow into and out of the first chamber 15.

The pneumatic actuator 91 further comprises a further fluid passage 19' for the second chamber 14. The further fluid passage 19' enables fluid flow into and out of the second chamber 14.

The system 1 also comprises a first control valve 21 connected to the first fluid passage 19 and to a fluid supply and configured to provide controlling of fluid flow into the first chamber 15 and/or to varying pressure in the first chamber 15. The first control valve 21 may be a proportional control valve capable of providing a defined fluid flow as a function of a respectively applied controlling signal. The control valve 21 provides controlled varying of a flow and/or pressure into the chamber 15.

A first fluid sensor 22 is arranged and configured to measure the pressure in the first chamber 15, i.e. at one side of the pneumatic cylinder. Here, the first fluid sensor is embodied as a pressure sensor 22 and provides pressure feedback from the first chamber 15, i.e. a pressure affecting the moving member 13. In an alternative embodiment, the first fluid sensor 22 can be a flow meter to measure fluid flow out of the control valve 21 and/or into the chamber 15. Such flow meter can also provide to measure fluid flow out of the chamber 15.

As shown, the first fluid sensor 22 is built integrated with the control valve 21.

The system comprises an additional combination of fluid sensor 92 and control valve 93 to provide controlling and measuring of fluid flow or pressurization of the second chamber14.

The vacuum system 1 comprises a controlling unit 30. The controlling unit 30 is configured to control a movement of the moving member 13 by applying particular pressures in the chambers 14 and 15. The pressures in the chambers 14 and 15 can be varied by controlling the control valves 21 and 93 to individually increase or decrease the pressures in the chambers 14 and 15.

As described in more detail above, the controlling unit 30 is configured to derive and generate respective controlling signals for the first control valve 21 and for the additional control valve 93. The controlling signals can provide to set and vary a pressure inside of the first chamber 15 and inside of the second chamber 14 and, by that, to set and vary a force applied to the moving member 13. A pressure difference between the two chambers 14 and 15 can respectively be set and varied. Respectively, an acceleration, velocity and/or position of the moving member or the mount can be determined and derived.

Hence, the controlling parameters for the vacuum valve 80 can be derived by at least varying pressure or control flow in/into the first chamber 15 and monitor the movement of the moving member as a function of the changing pressure or of the flow. By that, a respective learning or training of the controller 30 can be provided.

In addition, a respective controlling signal for the additional control valve 93 and respective pressure of flow measurements of the additional sensor 92 can be considered to drive the controlling parameters.

Referring to an adjusting of the motion profile of the pneumatic positioning device the adjusting cycle can be performed as described above. Based on a determined motion deviation, here, the controlling signal of either one of the control valves 21,93 or of both controlling signals can be adjusted to adjust a development of the pressure difference when applying the signals and by that changing the motion profile.

The actuator 91 is designed in such a way that the closure plate 84 can be moved from an open position to the intermediate position shown here by moving the valve rod 83 along the geometric longitudinal axis in a longitudinal closing direction z from an open position to the intermediate position shown here, and by adjusting the valve rod 83 along the geometric transverse axis extending at right angles to the longitudinal axis in a transverse closing direction y from the intermediate position to a closing position and back (movement of the closure plate is L-shaped, hence the designation L-type).

The vacuum valve 80 or its opening 81 is designed to be connected to a vacuum process chamber. A process atmosphere in this chamber expands in such a connection up to and including the vacuum region of the vacuum valve 80. In other words, a process atmosphere region is formed which includes at least both the volume of the vacuum chamber and the vacuum region of the vacuum valve 80. This process atmosphere region is separate from an outer atmosphere region due to the sealed bellows 85. The drive region is part of the outer atmosphere region.

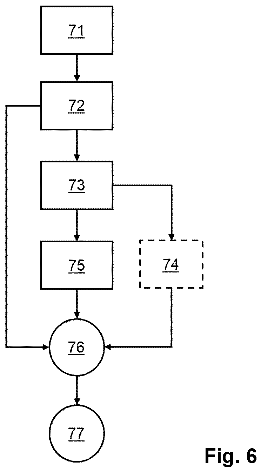

Figure 6 schematically shows the steps of performing an embodiment of a method according to the invention.

Before applying a controlling signal to the pneumatic positioning device, the lift pin or valve disk (and the respective mount of the pneumatic positioning device) is provided in a respective starting position (step 71). For example, the mount and/or the moving member can be moved to the lowest possible retracted position. Such starting position can be well known due to the structural design of the pneumatic positioning device.

The starting position may alternatively be any other position known and providable by the mount and/or the moving member.

In a next step 72, a controlling signal is applied to the control valve. As described above, the control valve is connected to the pneumatic actuator of the pneumatic positioning device and enables to move the effecting element (e.g. lift pin or valve disk) of the pneumatic positioning device by changing the pressure in the actuator. The control valve can be provided by a proportional control valve and is preferably connected to a high pressure source to increase the pressure in the actuator and also provides an exhaust path to vent the actuator.

Hence, by applying the controlling signal, the pressure in the actuator changes and, as a result, the mount of the pneumatic positioning device is moved from the starting position to an end position (step 73). The end position can also be well known and can e.g. be defined by a greatest possible extension of the mount. In particular, a distance between the starting position and the end position is known as well. Such distance can further be considered or processed to determine the controlling parameters and/or the digital model.

With concurrent step 74, the change of the pressure is monitoring by means of the arranged fluid sensor.

During the pressure is increased, the mount is monitored for if and when it reaches the end position. A respective arrival of the mount at the end position is determined, respectively (step 75). A respective time step and/or a duration or moving the mount can be derived accordingly. A respective detection of the arrival at the end position can be provide by monitoring the pressure development and detecting a deviation from a homogeneous or linear pressure increase.

In a next step 76, the controlling parameters for controlling the control valve (and by that the pin lifting device) are derived based on processing the observed inputs like the controlling signal, the varying pressure, and the information concerning the arrival of the mount at the end position.

Furthermore, a digital data model is derived also based on processing the observed inputs (step 77). Such model provides to estimate or calculate particular states of the pneumatic positioning device by processing currently provided inputs as described above.

It is understood that the depicted figures only schematically depict possible exemplary embodiments. The various approaches can according to the invention also be combined with one another and with prior art methods and devices for controlling of a pneumatic positioning device.

## Claims

1. Method for providing controlling parameters for controlling a vacuum system (1), the vacuum system (1) comprises
• at least a first pneumatic positioning device (10,40,50,80) configured for moving and positioning an effecting element (20,20',84), wherein the first pneumatic positioning device (10,40,50,80) comprises
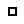 a first mount (17,47,87) configured to hold the effecting element, and
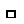 a first pneumatic actuator (11,41,91) which is connected to the first mount (17,47,87) and which interacts with the first mount (17,47,87) in such a way that the first mount (17,47,87) is movable along a first movement axis (M1,M2),
• a first control valve (21,23,27) connected to the first pneumatic actuator (11,41,91) and to a first fluid supply (35) and configured to vary at least one of the pressure in the first pneumatic actuator (11,41,91) or the fluid flow out of or into the first pneumatic actuator (11,41,91) to provide movement of the first mount (17,47,87), and
• a first fluid sensor (22,24,28) arranged and configured to measure at least one of the pressure of the first pneumatic actuator (11,41,91) or the fluid flow out of or into the first pneumatic actuator (11,41,91),
**characterized in that**
the method comprises
• applying a first controlling signal to the first control valve (21,23,27) to vary at least one of the pressure of the first pneumatic actuator (11,41,91) or the fluid flow into the first pneumatic actuator (11,41,91) and, by that, moving the first mount (17,47,87) from a first starting position to a first end position,
• monitoring at least one of the varying pressure of the first pneumatic actuator (11,41,91) or the varying fluid flow into the first pneumatic actuator (11,41,91) by means of the first fluid sensor (22,24,28),
• determining when the first mount (17,47,87) arrives at the first end position, and
• deriving the controlling parameters based on processing a set of observed parameters, wherein the set of observed parameters comprises at least
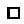 the first controlling signal,
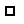 at least one of the varying pressure or the varying fluid flow, and
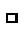 an information concerning the arrival of the first mount (17,47,87) at the first end position.

2. Method according to claim 1, wherein
the method comprises at least one of the following:
• the set of observed parameters comprises an information concerning the first starting position and the first end position, and
• the controlling signal is monitored and an information about a development or variation of the controlling signal provides an additional parameter of the set of observed parameters.

3. Method according to claim 1 or 2, wherein
at least one of the following is provided to determine the arrival of the first mount (17,47,87) at the first end position
• the varying pressure of the first pneumatic actuator (11,41,91) or the varying fluid flow is processed and the arrival of the first mount (17,47,87) at the first end position is determined based on the varying pressure or the varying fluid flow, or
• the vacuum system (1) comprises a position sensor (64) to measure the position of the first mount (17,47,87) and the arrival of the first mount (17,47,87) at the first end position is determined based on measuring or monitoring the position of the first mount by means of the position sensor (64).

4. Method according to any of the preceding claims, wherein
• the vacuum system (1) comprises at least one temperature sensor (65) configured and arranged to provide temperature information by measuring at least one of
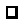 an ambient temperature,
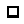 a temperature related to of the first pneumatic positioning device (10,40,50,80), and
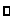 a temperature related to the first control valve (21,23,27), wherein
• the temperature information is determined by means of the at least one temperature sensor (65), and
• the temperature information is provided as an additional parameter of the set of observed parameters to be processed.

5. Method according to any of the preceding claims, wherein
• the vacuum system (1) comprises at least one fluid flow sensor configured and arranged to provide flowrate information by measuring at least one of
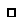 a fluid flow between the first control valve (21,23,27) and the first pneumatic actuator (11,41,91),
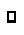 a fluid flow between the first control valve (21,23,27) and the first fluid supply (35), and
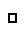 an exhaust fluid flow out of the first control valve (21,23,27), wherein
• the flowrate information is determined by means of the at least one fluid flow sensor, and
• the flowrate information is provided as an additional parameter of the set of observed parameters to be processed.

6. Method according to any of the preceding claims, wherein
• the vacuum system (1) comprises at least one pressure sensor configured and arranged to provide pressure information by measuring at least one of
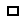 an inlet pressure into the first pneumatic actuator (11,41,91),
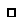 an outlet pressure downstream the first control valve (21,23,27),
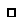 a supply pressure provided by the first fluid supply (35),
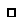 an exhaust pressure related to an exhaust line connected to the first control valve (21,23,27), and
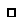 an ambient pressure, and
• the pressure information is determined by means of the at least one pressure sensor, and
• the pressure information is provided as an additional parameter of the set of observed parameters to be processed.

7. Method according to any of the preceding claims, wherein
a position of the first mount (17,47,87) is estimated based on processing of the set of observed parameters.

8. Method according to any of the preceding claims, wherein
a digital model is provided based on the set of observed parameters, the model representing dynamic properties of the at least first pneumatic positioning device (10,40,50,80) by model state variables, the model state variables are related to physical properties of the first pneumatic positioning device (10,40,50,80) and provide deriving of an actual state of the first pneumatic positioning device (10,40,50,80).

9. Method according to claim 8, wherein
the method comprises at least one of the following:
• the controlling parameters are derived based on the model state variables,
• the model state variables represent the controlling parameters,
• an actual position of the first mount (17,47,87) is determined by deriving the actual state of the first pneumatic positioning device (10,40,50,80), and
• an influence on at least one of the physical properties of the first pneumatic positioning device (10,40,50,80) is determined or estimated based on the actual state of the first pneumatic positioning device (10,40,50,80).

10. Method according to any of the preceding claims, wherein
at least one of the following is performed:
• an actual pressure of the first pneumatic actuator (11,41,91) is measured by the first fluid sensor (22,24,28) and an actual load affecting the mount (17,47,87) is derived by processing the model state variables or the set of observed parameters and the actual pressure,
• the actual load affecting the mount (17,47,87) is continuously monitored by continuously measuring the actual pressure of the first pneumatic actuator (11,41,91) and continuously deriving the actual load, and
• the derived actual load is compared to an expected load and a load information is derived by the comparison.

11. Method according to any of the preceding claims, wherein
• a first dynamic target behavior for the first pneumatic positioning device (10,40,50,80) is derived based on the set of observed parameters,
• the first pneumatic positioning device (10,40,50,80) is driven according to a production cycle and, concurrently, a first actual dynamic behavior of the first pneumatic positioning device (10,40,50,80) is derived, and
• a behavior deviation information is derived and provided based on comparing the first dynamic target behavior and the first actual dynamic behavior.

12. Method according to any of the preceding claims, wherein
the method provides second controlling parameters for controlling the vacuum system (1), the vacuum system (1) comprises a second pneumatic positioning device (40), which comprises
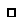 a second mount (47) configured to hold at least one effecting element (20'), and
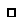 a second pneumatic actuator (41) which is connected to the second mount (47) and which interacts with the second mount (47) in such a way that the second mount (47) is movable along a second movement axis (M2),
• a second control valve (23) connected to the second pneumatic actuator (41) and to a second fluid supply and configured to control at least one of pressurizing of the second pneumatic actuator (41) or fluid flow out of or into the second pneumatic actuator (41) to provide movement of the second mount (47), and
• a second fluid sensor (24) arranged and configured to measure at least one of pressurization of the second pneumatic actuator (41) or fluid flow out of or into the second pneumatic actuator (41),
the method comprises
• applying a second controlling signal to the second control valve (23) to vary at least one of the pressure of the second pneumatic actuator (41) or the fluid flow into the second pneumatic actuator (41) and, by that, moving the second mount (47) from a second starting position to a second end position,
• monitoring at least one of the varying pressure of the second pneumatic actuator (41) or the varying fluid flow into the second pneumatic actuator (41) by means of the second fluid sensor (24),
• determining when the second mount arrives at the second end position, and
• deriving the second controlling parameters based on processing a second set of observed parameters, wherein the second set of observed parameters comprises at least
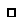 the second controlling signal,
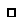 at least one of the varying pressure of the second pneumatic actuator or the varying fluid flow, and
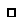 an information concerning the arrival of the second mount at the second end position.

13. Method according to any of the preceding claims, wherein
• the first pneumatic positioning device is a pin lifting device (10,40) for moving and positioning a substrate (5) to be processed by means of a lift pin (20,20'),
• the mount (17,47) is configured to hold the lift pin (20,20') designed for contacting and supporting the substrate (5) and forming the effecting element, and
• the first pneumatic actuator (11,41) provides a linear adjustability of the mount (17,47),
or
• the first pneumatic positioning device is a vacuum valve (80) for regulating a volume or mass flow or for gas-tight interruption of a flow path, the vacuum valve (80) comprises
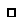 a valve seat (82) comprising a valve opening (81) defining an opening axis (O) and a first sealing surface surrounding the valve opening (81), and
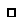 a valve closure (84) forming the effecting element having a second sealing surface corresponding to the first sealing surface, wherein
• the valve closure (84) is coupled to the pneumatic actuator (91) by means of the mount (87) in such a way that the valve closure (84) is adjustable from an open position, in which the valve closure (84) and the valve seat (82) of the vacuum valve (80) are present in a contactless manner relative to each other, to a closed position, in which a sealing contact between the first sealing surface and the second sealing surface exists via an interposed seal and the valve opening (81) is thereby closed, and is adjustable back again, and
• the mount (87) is designed to hold the valve closure (84).

14. Controlling unit (30) for a vacuum system (1), the vacuum system (1) comprises
• at least a first pneumatic positioning device (10,40,50,80) configured for moving and positioning an effecting element, the at least first pneumatic positioning device (10,40,50,80) comprises
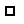 a first mount (17,47,87) configured to hold the effecting element (20,20',84), and
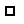 a first pneumatic actuator (11,41,91) which is connected to the first mount (17,47,87) and which interacts with the first mount (17,47,87) in such a way that the first mount (17,47,87) is movable along a first movement axis (M1,M2),
• a first control valve (21,23,27) connected to the first pneumatic actuator (11,41,91) and to a first fluid supply (35) and configured to vary at least one of the pressure in the first pneumatic actuator (11,41,91) or the fluid flow out of or into the first pneumatic actuator (11,41,91) to provide movement of the first mount (17,47,87),
• a first fluid sensor (22,24,28) arranged and configured to measure at least one of the pressure of the first pneumatic actuator (11,41,91) or the fluid flow out of or into the first pneumatic actuator (11,41,91),
**characterized in that**
the controlling unit is configured to
• apply a first controlling signal to the first control valve (21,23,27) to vary at least one of the pressure of the first pneumatic actuator (11,41,91) or the fluid flow into the first pneumatic actuator (11,41,91) and, by that, moving the first mount (17,47,87) from a first starting position to a first end position,
• monitor at least one of the varying pressure of the first pneumatic actuator (11,41,91) or the varying fluid flow into the first pneumatic actuator (11,41,91) by means of the first fluid sensor (22,24,28),
• determine when the first mount (17,47,87) arrives at the first end position, and
• derive the controlling parameters based on processing a set of observed parameters, wherein the set of observed parameters comprises at least 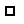 the first controlling signal,
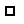 at least one of the varying pressure or the varying fluid flow, and
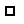 an information concerning the arrival of the first mount at the first end position.

15. Computer program product stored on a machine-readable carrier, in particular stored in a controlling unit (30) according to claim 14, or embodied by an electromagnetic wave with a program code segment, with program code for performing or controlling a method according to any one of claims 1 to 13, wherein the computer program product comprises computer-executable instructions for performing the method according to any one of claims 1 to 13, in particular wherein the computer program product is configured such that when it is executed, the steps of the method according to any one of claims 1 to 13 are performed automatically.
